## Europäisches Patentamt
## European Patent Office
## Office européen des brevets

(19)

(11) Publication number: **0 002 135**
**B1**

(12)

# EUROPEAN PATENT SPECIFICATION

(45) Date of publication of patent specification: **03.11.82**

(21) Application number: **78300647.1**

(22) Date of filing: **20.11.78**

(51) Int. Cl.³: **C 01 B 33/02, C 30 B 15/00**

(54) **Improved refined metallurgical silicon and process for the production thereof.**

(30) Priority: **21.11.77 US 853578**
**21.11.77 US 853759**
**21.11.77 US 853760**
**21.11.77 US 853763**

(43) Date of publication of application:
**30.05.79 Bulletin 79/11**

(45) Publication of the grant of the patent:
**03.11.82 Bulletin 82/44**

(84) Designated Contracting States:
**BE DE FR GB NL**

(73) Proprietor: **UNION CARBIDE CORPORATION**
**Old Ridgebury Road**
**Danbury Connecticut 06817 (US)**

(72) Inventor: **Kotval, Peshotan Sohrab**
**8 Verne Place**
**Hartsdale (US)**
Inventor: **Strock, Harold Bunsen**
**143 Webber Avenue**
**North Tarrytown New York (US)**

(74) Representative: **Blake, John Henry Francis**
**BROOKES AND MARTIN High Holborn House**
**52/54 High Holborn**
**London WC1V 6SE (GB)**

(56) References cited:
**DE - B - 1 022 806**
**GB - A - 874 547**
**GB - A - 894 132**
**US - A - 3 097 068**
**US - A - 3 871 872**
**US - A - 3 933 981**

**CHEMICAL ABSTRACTS, vol. 61, no. 8, October 12., 1964, 9194e, Columbus, Ohio, USA, SHIMESU IMAI et al. "Removal of impurities in ferrosilicon"**

(56) References cited:
**EXTENDED ABSTRACTS, The electrochemical Society, Inc. Spring Meeting, Washington, D.C., vol. 76—1, May 2—7, 1976 L. P. Hunt et al. "Purification of metallurgical-grade silicon to solar-grade quality", page 560, abstract no. 227 (in English)**
**CHEMICAL ABSTRACTS, vol. 89, no. 8, August 21., 1978, Columbus, Ohio, USA, I. M. SEDYKH et al. "Refining of silicon with synthetic slag", page 204, column 1, abstract no. 63030t**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Improved refined metallurgical silicon and process for the production thereof

This invention relates to low-cost refined, metallurgical silicon materials. More particularly, it relates to the production of such silicon materials having desirable properties for solar cell applications.

The development of new techniques and products for the low-cost utilization of non-polluting sources of energy is of paramount national and world-wide interest. Solar energy is among the energy sources of greatest interest because of its non-polluting nature and of its abundant, non-diminishing availability. Two separate approaches have been utilized in efforts to develop solar energy as a suitable energy source for satisfying significant portions of the ever-increasing energy requirements of modern, industrial societies. In one approach, solar energy is converted into thermal energy, while the second approach involves the conversion of solar energy into electricity by means of the photovoltaic effect upon the absorption of sunlight by so-called solar cells. The present invention relates to the second approach and to the development of low-cost silicon materials for use in such solar cells.

Silicon solar cells, the most commonly employed devices based on said photovoltaic effect, have been employed reliably in space craft applications for many years. For such applications and for industrial and commercial applications in general, crystals of high purity, semiconductor grade silicon is prepared by rather costly procedures involving converting metallurgical grade silicon to trichlorosilane, which is then reduced to produce polycrystalline, semiconductor grade silicon from which single crystals can be grown. The costs associated with the production of such high purity, high perfection crystals are high. For example, polycrystalline semiconductor grade silicon made from metallurgical grade silicon costing about U.S. $ 1.10/kg. will presently cost on the order of about U.S. $ 66/kg. and up. A single crystal is grown from this semiconductor grade material, the ends of the single crystal ingot or boule are cut off, and the boule is sawed, etched and polished to produce polished wafers for solar cell application, with mechanical breakage and electronic imperfection reducing the amount of useable material obtained. As a result of such processing, less than 20% of the original polycrystalline, semiconductor grade silicon will generally be recovered in the form of useable wafers of single crystal material. The overall cost of such useable material is, accordingly, presently on the order of about US. $ 660/kg. and up. Because of the relatively large area requirements involved in solar cell applications, such material costs are a significant factor in the overall economics of such applications.

The economic feasibility of utilizing solar cell technology for significant portions of the present and prospective needs for replenishable, non-polluting energy sources would be enhanced, therefore, if the utilization of high cost, high purity, high perfection single crystal wafers could be avoided. Previous efforts to refine metallurgical silicon for other applications, however, have not resulted in the production of materials that can be utilized in solar cells although the electronic characteristics of various grades of silicons for solar cells are less stringent than, for example, such silicons as employed for complex circuitry in the electronics industry.

An article entitled "Purification of Metallurgical Grade Silicon to Solar-Grade Quality" by L. P. Hunt et al, Abstract No. 227, Vol. 76—1, of Extended Abstracts of the Electrochemical Society Inc. Spring Meeting May 2—7 1976, gives a survey of various alternative silicon purification techniques which could be used in the solar cell field, such as reactive gas blowing, slagging, acid leaching and unidirectional solidification.

Metallurgical silicon has heretofore been refined by slag oxidation to obtain to a grade of metallurgical silicon or ferrosilicon advantageous as an alloying additive in the manufacturing of steels. As indicated in the Barber et al patent, U.S.—A—2,797,988, and elsewhere, the slag oxidation approach has been utilized to remove impurities and thus to purify and refine silicon having an iron content therein such that the refined product constitutes a ferrosilicon in which iron is considered an integral part of the final refined product. For use of silicon as a substrate in planar diodes and solar cells made therefrom, however, it is necessary that the refined silicon have as low an iron content as possible, as such iron is a deleterious impurity in a solar cell material. As indicated above, this circumstance is a contradistinction to the benign nature of the iron content of the refined silicon product as utilized in the steel industry.

Silicon has also been purified heretofore by the dissolution and subsequent precipitation of silicon from a liquid metal system. Such purification, taught by Litz, U.S.—A—3,097,068 and Wakefield U.S.—A—3,933,981, involves the retention of silicon impurities by the liquid metal solvent when dissolution takes place at a higher temperature and, subsequently, the temperature is lowered to precipitate a relatively pure silicon. Such a silicon product is not suitable for use as a substrate in solar cell applications, however, since the liquid metal of the solvent phase is present as an impurity in the product silicon so obtained in this processing technique.

While Litz states that the product of such refining by liquid metal solvent is too impure for use in transistors, use for rectifiers and solar batteries is indicated. The product, however, is said to contain 200 to 700 ppm of aluminum, with no mention of its iron content. Such a level of aluminum would render the product purified by the Litz technique unsuitable for solar cell application. Litz also discloses a further lengthy and expensive procedure using silicon tetrachloride to reduce the aluminum content to 9 ppm.

Other efforts to develop acceptable solar cell materials have likewise resulted either in high cost, or high impurity levels such that acceptable efficiencies can not be obtained, or a combination of these disadvantages. An acceptable efficiency for a low-cost, relatively impure silicon would, of course, very likey represent some loss from the high purity, single crystal material made from semiconductor grade silicon. Such high-cost material is capable of providing efficiencies of about 13—14%. The lower cost of relatively impure silicon material, particularly multigrained material, might well constitute an advantageous trade-off enhancing the overall technical economic feasibility of utilizing silicon solar cell technology in significant commercial operations.

The practical lower limit for economic solar cell efficiencies is about 7—8%. One attempt to produce an acceptable low-cost material has involved pulling of ribbons from a melt of metallurgical grade silicon by known techniques. While such ribbons pulled from semiconductor grade material have obtained efficiencies of up to 10%, the ribbon pulled from metallurgical silicon is relatively dirty and impure, with solar cell efficiencies obtained from such ribbon being limited to about 5%.

Another approach has involved the pulling of boules, in a multiple series of refining steps, from metallurgical grade silicon as a starting material by the known Czochralski-pulling technique. By remelting and repulling refined, multigrained silicon in a several stage process, a single crystal refined silicon is ultimately obtained that is capable of achieving efficiencies of about 8%. The cost of such material, is relatively high because of the multiple pulling steps involved.

Chu, U.S.—A—3,961,997, discloses the fabrication of low-cost solar cell substrates from metallurgical grade, polycrystalline silicon. In this approach, successive layers of a polycrystalline silicon containing appropriate dopants are deposited over substrates of metallurgical grade silicon, graphite or steel coated with particular diffusion barrier materials. The resulting products contain a high level of impurities such that efficiencies obtainable by modifications of this approach have not exceeded about 3—5%.

A genuine need thus exists for lost-cost, relatively impure silicon products suitable for use in solar cells of acceptable efficiency. the resulting low-cost solar cells should preferably have efficiencies in excess of about 10%, with 7—8% representing a practical lower limit of efficiency as indicated above.

This need can be satisfied in accordance with the present invention by the slag oxidation of partially purified silicon platelets precipitated in an essentially iron-free form from a solution of metallurgical grade silicon in a molten liquid solvent and treated to remove adherent impurities, thereby producing a refined metallurgical silicon (RMS), and desirably pulling, by the Czochralski method, multigrained boules of said RMS from a melt thereof. By solidifying the silicon-slag melt from the slag oxidation operation in a unidirectional manner, a directionally solidified refined metallurgical silicon (DS/RMS) is obtained, with multigrained DS/RMS boules pulled from a melt of said DS/RMS having particularly advantageous solar cell properties. By remelting and solidifying said DS/RMS in a unidirectional manner a second time, single crystal DS/RMS boules can be obtained having further advantages upon incorporation in planar diodes and solar cells made therefrom. Said single crystal DS/RMS, and said multigrained RMS and DS/RMS, are obtained as a substantially higher impurity content level than in conventional high purity semiconductor grade material while such RMS and DS/RMS products are, nevertheless, of sufficient purity to permit such products to be used advantageously as low-cost substrates in planar diodes and solar cells made therefrom.

The present invention provides a low-cost alternative to the utilization of semiconductor grade material in the development and application of solar cell technology. While high-cost, high-purity, high-perfection single crystal silicon wafers are undoubtedly of value for specialized solar cell applications, the necessity for achieving a more commercially feasible cost structure is a major factor in the growth and development of solar cell technology for general industrial and commercial applications. As noted above, the large area requirements of solar cells, which are, in effect, simple large area planar diodes, render material costs a significant factor in the economic feasibility of solar cells vis-a-vis other presently available energy sources. By means of the present invention, practical, large-scale solar cells can be made from grades of silicon having substantially higher impurity levels than in the extremely high purity semiconductor grade silicon heretofor employed for solar cell purposes.

Semiconductor grade silicon from which high cost, high purity single crystals are grown generally has a resistivity, measured as a manifestation of uncompensated charge carriers, of from 1 to 10 ohm-cm or higher, with the resulting single crystal wafers prior to junction formation having resistivities of on the order of 50 to 200 ohm-cm. The present invention on the other hand, utilizes low-cost refined metallurgical products having resistivities in the range of from 0.04 to 0.2 ohm-cm. While high cost, high purity single crystal wafers have very low impurity element that are beyond the limits of detection by normal chemical analytical procedures and are manifest by resisitivity measurements, the low-cost refined metallurgical products of the present invention can have significantly higher impurity levels for various of said significant impurity elements while, nevertheless, having sufficient overall purity to serve as a practical solar cell substrate having a p-n junction grown on, or diffused therein, by known epitaxial or diffusion methods.

In the practice of the present invention, metallurgical grade silicon is refined but without conversion to semiconductor grade material. Metallurgical grade silicon, as referred to herein, is a grade of silicon having a resistivity on the order of 0.005 ohm-cm and up to 3% iron, up to 0.75% aluminum, up to 0.5% calcium and other impurities normally found in silicon produced by the carbothermic reduction of silica. It is also within the scope of the invention to employ a ferrosilicon material containing at least about 90% Si and up to 10% or more of iron. Such metallurgical grade silicon or ferrosilicon is processed, for purposes of the present invention, by solvent refining to reduce the iron content and other impurities after which the partially purified silicon is melted in contact with acid silica slag with the resultant slag oxidation producing a refined metallurgical silicon (RMS) from which other products useful in solar cell applications are produced as described herein.

In the initial iron removal step, silicon platelets essentially free of iron are removed from a solution of metallurgical grade silicon in a liquid metal solvent. While such metals as tin, zinc and silver may be employed, aluminum is the preferred solvent for use in the practice of the present invention. It will be understood that the term "aluminum" is intended to cover aluminum and alloys of aluminum. Primary ingots of 99.5% to 99.9% purity and above may be used, with 99.9% nominal purity primary aluminum ingot being preferred. Aluminum alloys are also generally suitable for purposes of the invention. One such alloy that has been used contains 1% silicon and iron, 0.2% copper, 0.05% manganese and 0.1% zinc. Another such alloy contains 0.21% iron, 3% copper, 0.025% manganese, 0.88% magnesium and 0.2% chromium. The solvent purity decreases, of course, with increasing cycles of fresh silicon charge dissolution therein.

The temperature and aluminum (or other metal)/silicon ratio limits used in dissolving the metallurgical grade silicon are determined by the metal-silicon binary phase diagram. Employing aluminum as the metal solvent, silicon must be removed by cooling the liquid solution of silicon in molten aluminum to a temperature not below the eutectic temperature of about 577°C, thus forming a super saturated hypereutectic aluminum-silicon solution and causing silicon platelets to precipitate therefrom. At the eutectic temperature, 11.7% silicon is dissolved in aluminum. A homogeneous solution is formed at the high temperature dissolution point with up to 80% silicon in aluminum, preferably between 55% silicon at 1100°C and 20% silicon at about 700°C, although temperatures closer to 600°C may be feasible depending on the precision of the silicon-aluminum separation procedures employed. While silicon will commonly be added to molten aluminum or other liquid metal solvent, it is within the scope of the invention to add aluminum or other metal to molten silicon.

In cooling the solution, rapid cooling rates produce smaller precipitated silicon platelets than more costly, slower cooling rates. The solution should preferably be cooled at the fastest rate that will produce platelets of acceptable purity and size. Platelets of 0.64 cm. (1/4") or larger, suitable for ready separation from the silicon-aluminum melt by filtration, have been obtained at a cooling rate of 60°C/hour, with no advantage having been obtained at slower cooling rates down to 20°C/hour. The upper range of such cooling rates will likely depend on the geometry of the particular apparatus employed and will likely be in the order of about 200°C/hour, with heat transfer limitations possibly dictating the fastest cooling rates possible for large melts.

The solvent refining step of the invention may be carried out in any crucible that does not react with and/or contaminate the silicon-solvent metal alloy melt. Carbon or graphite crucibles are preferred but other non-reactive materials, such as refractory oxides, can also be employed. A non-oxidizing atmosphere, such as nitrogen, argon, helium or hydrogen-carbon monoxide mixtures can be employed to maximize the life of the crucible and related heating elements. While mechanical or other stirring is optional after the refined metallurgical silicon and metal solvent have been mixed, it is desirable to continue stirring during silicon dissolution, but stirring may be undesirable during silicon precipitation if it creates small platelet sizes such as to make platelet separation from the melt difficult.

While the invention is herein described particularly with reference to aluminum as the liquid metal solvent, it will be appreciated that the processing is applicable to embodiments in which other suitable solvents, such as those disclosed above, are employed, particular operating conditions, such as temperatures, metal/silicon ratios, cooling rates and the like being varied depending on the particular characteristics of any specific metal-silicon system.

For practical, commercial operations, the platelets will range generally from 0.25 to 2.5 cm. (1/10 to 1 inch) in size and will be removed from the solution of metallurgical grade silicon in the aluminum or other liquid metal solvent while it is still molten. For this purpose, the entire melt can be filtered through a suitable filter, such as perforated carbon plates, quartz wool and stainless steel screens. The partially purified, essentially iron-free silicon platelets float on the melt and, in an alternate removal technique, can be scooped from the solution melt surface as a semi-solid mass comprising said platelets and excess aluminum-silicon eutectic. In a generally preferred approach, this mass is subjected to centrifugal filtration to separate the partially purified silicon platelets from said excess eutectic material. The recovered essentially iron-free platelets will nevertheless have some adherent impurities derived from the metal solvent associated therewith. For example, using a centrifugal filter operating at 400 rpm, silicon platelets having only about 9% aluminum can be obtained from a semi-solid mass of crystallized platelets and eutectic fed to said filtration step at an overall gross composition of approximately 50% aluminum/50% silicon.

The adherent material, e.g. aluminum-silicon eutectic, is advantageously removed from the filtered platelets before the partially purified platelets are contacted with silica slag to produce a refined metallurgical silicon (RMS). In one embodiment of the invention, such adherent impurities can be removed from the platelets by acid leaching, with any suitable aqueous inorganic acid solution being employed in a wide range of suitable concentrations. Aqueous HCl solutions in concentrations of about 4 to about 37% by weight are generally preferred. To assure complete washing, the platelets are desirably crushed and passed for example, through a 6 mesh screen, boiled in concentrated aqueous HCl for up to an hour, and finally washed in boiling water. The mesh sizes used in the specification are based on US. Standard Sieve Series.

In an alternate embodiment, the adherent eutectic may be removed from the filtered platelets by washing the platelets with anhydrous alcohols, e.g. isopropyl alcohol or amyl alcohol, said alcohols reacting with the aluminum in said eutectic to form aluminum alkoxides, i.e. $Al(OR)_3$. The alkoxide has a resale value and, in a further embodiment, can be hydrolyzed to form hydrous aluminum oxide and the alcohol, which can be recycled for the washing of additional platelets. This embodiment thus represents a clean closed cycle process that may be less expensive than the acid leach referred to above even if a final HCl or other acid leach step were employed for the partially purified silicon material thus washed with said anhydrous alcohol.

Following the removal of adherent eutectic, the partially purified silicon will be essentially iron-free, having an iron content generally within the range of from 3 to 90 ppm, more typically, not exceeding about 20 ppm, i.e. parts per million parts by weight of said purified material. The aluminum content of said material will generally be in the range of from 0.1 to 0.5% by weight of said material, typically about 0.2% by weight. It is believed that the acid leaching or alcohol washing may effect some impurity removal beyond the removal of said eutectic. Iron removal in the eutectic removal operation would, of course, represent a further advantage—compensating in part for the cost of said step and its related waste acid environmental considerations.

The partially purified silicon platelets, essentially free of iron, are thereafter melted in contact with a silica slag in a melting zone to remove residual and adherent impurites from the platelets. While the solvent refining step described above results in a drastic reduction in the iron and titanium content of metallurgical silicon, microscopic inclusions of aluminum eutectic remains within the platelets. The slag oxidation occurring upon contact of the partially purified platelets with said silica slag results in the removing of residual and adherent impurities, including said aluminum eutectic, that are detrimental to the production of an acceptable solar cell substrate material capable of achieving a satisfactory level of solar cell efficiency. It will be understood that the platelets thus exposed to slag oxidation include such platelets as treated by means such as those above, including crushing, for the removal of adherent impurities from the partially purified platelets.

The partially purified silicon is contacted with said slag at temperatures above the melting point of silicon, e.g. at temperatures of from 1410°C to 2000°C. Lower temperatures, from 1410°C to 1600°C, are more efficient for oxidative removal of aluminum from silicon, with temperatures of from 1410°C to 1500°C being generally preferred. Lower temperatures, e.g. down to about 750°C, are less preferred. In general, the slag melting point should be less than the highest silicon melt temperature during slagging for rapid reaction kinetics.

In the practice of the slag oxidation step of the invention, silicon metal platelets are mixed with high purity slag powder and the mixture is heated to the contact temperature range indicated above. Alternatively, high purity slag powder components, preferably at a temperature of from 1,000—1200°C, can be added directly to a melt of said silicon in a suitable crucible. Since the crucible must not contaminate the melt, most metal and metal carbides cannot be used therein. Carbon, silicon carbide, silicon nitride or silicon dioxide crucibles or crucible coatings are generally preferred. Any atmosphere that protects the crucible and melt from oxidation, such as argon, helium or nitrogen, is desirable with nitrogen being preferred for economic reasons.

The slag removes aluminum from the silicon, by oxidation, and dissolves the product

$Al_2O_3$ with low resultant activity as is generally known in the art. For this purpose, high silica acid slags, i.e. slags in which the Si/O ratio lies between 1/4 and 1/2, are employed. Since silicon reduces FeO and $TiO_2$ impurities in the slag and introduces them, as Fe and Ti, into the silicon, it is necessary that the highest purity slag components be employed for advantageous results.

The amount of slag employed will generally be on the order of from 8% to 12% by weight based on the weight of silicon although larger amounts up to 20% or more may also be employed. A slag content of about 10% is preferred, although it will be understood that commercially available slags may exist and have utility for purposes of the invention but at concentrations varying somewhat from those indicated herein. It is also within the scope of the invention to employ multiple slag steps, e.g. at said 10% slag concentration, to progressively lower the impurity level of the silicon being treated.

The slag should desirably contain less than about 10 ppm of each impurity reducible by molten silicon at the slag-silicon contacting temperature. Such impurities include FeO, $TiO_2$, $Cr_2O_3$ and $V_2O_5$.

Any commercially available, high silica acid slag composition can be employed for the aluminum and other impurity removal purposes of the present invention. Illustrative examples of such available slag compositions are those having 65—100% $SiO_2$, 0—20% MgO and 0—35% CaO, preferably 65% $SiO_2$, 10% MgO and 25% CaO; those having 45—55% $SiO_2$ 55—45% BaO, with 45% BaO/55% of $SiO_2$ being preferred; and those having 50—85% $SiO_2$, and 15—50% $Na_2O$, with 75% $SiO_2$/25% $Na_2O$ being preferred.

Enhanced slag-silicon contact speeds the purification reactions, and, thus stirring is preferred although the process is operable in the absence of stirring. Operable stirring rates are those that minimize melt splashing, such as rates of about 1—100 rpm.

After the slag oxidation reaction in the melting zone has removed residual and adherent impurities, particularly including aluminum, from the silicon, the thus-slagged silicon is removed from the melting zone and cooled, as by chill casting. The resulting solidified product is a low-cost, multigrained refined metallurgical silicon (RMS) having a substantially higher impurity content level than in conventional, high purity semi-conductor grade silicon but nevertheless constituting a valuable intermediate in the production of solar cell substrates.

In another embodiment of the invention, the silicon-slag melt is removed from the melting zone, following slag oxidation or without slag purification, in a unidirectional manner so as to directionally solidify the silicon. For this purpose, the silicon-slag melt is slowly withdrawn, in its refining crucible, from the melting zone, as by slowly lowering the refining crucible from said zone. For example, the invention has been practiced in operations in which the refining crucible has been slowly withdrawn from the melting zone at a rate of approximately 2.5 cm. (one inch) per hour. The slow withdrawal of the crucible results in the unidirectional solidification, or freezing, of the charge that initially is entirely molten. Such directional solidification results in the obtaining of solidified melt having a high concentration of impurities rejected by the refined silicon as it solidifies. Thus, there is no build-up of impurities at the solidification interface. The impurities remain uniformly distributed in the melt as silicon slowly solidifies in a unidirectional manner therefrom. The directionally solidified refined metallurgical silicon (DS/RMS) thus obtained is a low-cost multigrained silicon having a substantially higher impurity level than in conventional high purity semiconductor grade silicon while, at the same time, having suitable properties for desirable solar cell applications. It will be appreciated that it is also within the scope of the invention to re-melt said DS/RMS and to directionally solidify the silicon again to obtain further separation of refined silicon from a solidified melt of high impurity concentration. The DS/RMS can be mechanically separated from the solidified melt of the high impurity concentration, as by sawing, when the mass is cold. The solidified melt is waste material, the amount of which, in the embodiment in which slag oxidation of the partially purified platelets is omitted, considered in light of the simplified processing of this embodiment of the invention, provides an attractive trade-off in the development of low-cost solar cell materials.

Upon solidification of a silicon-slag melt, the interface between the slag and the silicon is not always well defined, resulting in the possibility of some material wastage. Upon directional solidification, the separation of silicon and slag is good. It has generally been found that when a quartz container is used to hold the reaction mixture, the slag is on the bottom and the silicon on the top, whereas the positioning appears to be reversed when a graphite crucible is employed. The DS/RMS having a large columnar grains can readily be mechanically separated from the solidified melt having small grains of high impurity concentration when the mass is cold.

The RMS and DS/RMS multigrained products produced in accordance with the present invention have resistivity values, using a 4-point probe method, within the range of from 0.04 to 0.20 ohm-cm, whereas semiconductor grade silicon has a resistivity of greater than 10 ohm-cm. The resistivity is a manifestation only of umcompensated charge carriers. The resistivity is determined by the number of uncompensated impurity atoms present, and is thus a measure of the utility of the silicon that is different than the range of chemical composition of the silicon. The chemical composition per se can be misleading since impurities of Group III and Group V elements compensate each other electronically. It will also be appreciated that the precise composition of any particular RMS or DS/RMS product will vary depending on a variety of the processing conditions set forth above, and on the composition of the metallurgical grade silicon starting material, the liquid metal solvent, the silica slag and various other factors. Because of all or a combination of these factors, the concentration of individual impurities in the product is subject to considerable variation, the overall impurity level being such that the low-cost, multigrained products of the invention have suitable properties for desirable solar cell and other silicon applications although said impurity level is substantially higher than in conventional high purity semiconductor grade material. Thus, the RMS product, having a resistivity of from 0.04 to 0.2 ohm-cm, typically 0.1 to 0.2 ohm-cm, may have impurity concentrations of up to, but not exceeding, 15 ppm of aluminum, 80 ppm of iron, and 15 ppm of titanium, 2 ppm of boron, 2 ppm of phosphorus, 10 ppm of chromium, 100 ppm of calcium and 65 ppm of magnesium. In particular embodiments of the invention, various impurities may have a concentration considerably below these limits and, it will be appreciated, concentrations of individual impurities may somewhat exceed the limits specifically set forth without significant deviation from the scope of the invention. Thus, aluminum and iron contents of on the order of 10 ppm have been obtained particularly with a calcium-magnesium type slag. While the use of a sodium-type slag has resulted in an aluminum content of about 5 ppm, the corresponding iron level was about 80 ppm. Likewise, calcium and magnesium levels of about 100 ppm and 63 ppm, respectively, were obtained when a calcium-magnesium slag was employed, with such levels being about 1 ppm and 4 ppm, respectively, when a sodium-type slag was employed. These examples will serve to illustrate the innumerable variations in composition obtainable for the RMS products of the invention within the overall composition levels and resistivity values indicated above. It will be appreciated that the term "ppm" as used herein shall mean parts per million by weight unless otherwise noted.

Likewise, the DS/RMS products of the invention have been found to have resistivity of from 0.04 to 0.2 ohm-cm, typically from 0.1 to 0.2 ohm-cm. Such products may have impurity concentrations of up to, but not exceeding, 1 ppm of aluminum, 1 ppm of iron, 2 ppm of titanium, 2 ppm of boron, 2 ppm of phosphorus, 1 ppm chromium, 1 ppm of calcium and 1 ppm of magnesium. Once again, it should be noted that various individual impurities may depart somewhat from the specific limits indicated without departure from the scope of the invention. It should also be noted that, although the impurity levels from DS/RMS are lower than for RMS, the resistivity values are within the same general range, denoting that the number of uncompensated impurity atoms was approximately the same at the different impurity concentration levels. As indicated above, semiconductor grade material will have resistivities of up to 10 ohm-cm or more, together with very low concentration levels beyond the limits of detection for each impurity. The RMS and DS/RMS of the present invention, therefore, represent relatively impure grades of silicon having, nevertheless, desirable utility in the production of solar cell substrates and for other known silicon applications, such as in rectifiers, where the purity requirements are less restrictive than in transistor use and specialized solar cell applications in which high purity silicon made from semiconductor grade material is required regardless of the cost thereof.

The DS/RMS products without slagging have been found to have a resistivity of from 0.04 to 0.2 ohm-cm. Such products may have impurity concentrations of up to, but not exceeding, 15 ppm of aluminum, 40 ppm of iron, 1 ppm of titanium, 2 ppm of boron, 2 ppm phosphorus, 0.5 ppm chromium, 0.5 ppm of calcium and 0.5 ppm of magnesium. It should be noted that various individual impurities may depart somewhat from the specific limits indicated without departure of the product from the scope of the invention. In addition, it will be appreciated that various impurities may be present in concentrations considerably below the indicated limits, as innumerable variations in composition are obtainable within the overall composition levels and resistivity values indicated herein. As indicated above, semiconductor grade material will have resistivities of greater than 10 ohm-cm together with concentration levels of less than 1 ppm for each impurity. The DS/RMS of the present invention, therefore, represent relatively impure grades of silicon having, nevertheless, desirable utility in the production of solar cell substrates and for other known silicon applications, such as in rectifiers, where the purity requirements are less restrictive than in transistor uses and specialized solar cell applications in which high purity silicon made from semiconductor grade material is required regardless of the cost thereof.

The RMS and DS/RMS materials as described above can be further refined by the well-known Czochralski pulling technique to produce desirable solar cell substrate materials. According to this technique, boules of further refined metallurgical silicon can be pulled, on a rotating silicon seed rod, from a melt of said RMS and DS/RMS materials. For this purpose, the seed rod is slowly moved, i.e. lifted, while maintaining an interface between the rod with said boule being grown thereon and the molten silicon, i.e. RMS or DS/RMS, from which said boules are pulled. In the application of this known technique for purposes of the present invention, boules of refined crystals have been grown employing a seed rod movement of about 9.1 cm. (3.6 inches) per hour, employing temperature gradients and seed rotation rates in combination therewith, consistent with the features of the particular boule pulling apparatus employed. The resulting boules pulled from an RMS melt, i.e. a Cz-RMS material, are low-cost, multigrained materials of sufficient purity so that wafers cut therefrom achieve an acceptable level of solar cell efficiency. Multigrained Cz-DS/RMS material can be obtained by the pulling of boules from a DS/RMS material prepared as indicated above. Somewhat higher solar cell efficiencies are obtainable with this material than with corresponding Cz-RMS material. It is also within the scope of the invention to separate the DS/RMS material, as originally prepared, from the region of solidified melt, to then re-melt said DS/RMS and to remove the resulting melt slowly from the melting zone, in a unidirectional manner, so as to directionally solidify the silicon a second time. A DS/RMS of enhanced purity is thus obtained and may be separated from a region of solidified melt having a high concentration of the remaining impurities therein. By pulling boules from the DS/RMS material, low-cost single crystal silicon is obtained. While said material, and the multi-grained Cz-RMS and Cz-DS/RMS materials indicated above, has a substantially higher impurity level than conventional, high purity semiconductor grade material, it nevertheless has sufficient purity to achieve very acceptable solar cell efficiencies when employed, in wafer form, as the solar cell substrate material. It will be appreciated that various processing techniques will be employed by those performing the Czochralski pulling form of crystal growth on a commercial basis to enhance the efficiency of said technique. Such techniques are not within the scope of the present invention since the pulling of boules as provided herein is a conventional step apart from its use in combination with the other features of the invention for the production of low-cost refined metallurgical silicon products. The Czochralski technique, which was first developed in about 1917 with regard to the withdrawal of seeds of Pb, Sn and Zn from the melt, is described in "Silicon Semi-conductor Technology" by W. R. Runyan (McGraw-Hill), pp. 34—39 and in "The Growth of Single Crystals" by R. A. Laudise (Prentice-Hall) (1970), pp 174—176.

The multigrained Cz-RMS product of the invention will have a resistivity value of from 0.1 to 0.2 ohm-cm, with impurity contents of up to, but not generally exceeding 1 ppm of aluminum, 1 ppm of iron, 0.5 ppm of titanium, and 2 ppm of boron, 2 ppm of phosphorus, 0.5 ppm of chromium, 0.5 ppm of calcium, and 0.5 ppm of magnesium. The multigrained Cz-DS/RMS product will have a resistivity value of 0.04 to 0.2 ohm-cm, with impurity concentrations of up to, but not exceeding, 0.2 ppm of aluminum, 0.15 ppm of iron, 0.03 ppm of titanium, 1.5 ppm of boron, 0.2 ppm of phosphorus, 0.02 ppm of chromium, 0.7 ppm of calcium and 0.05 ppm of magnesium. The single crystal Cz-DS/RMS will have a resistivity value of from about 0.05 to about 0.2 ohm-cm, with impurity concentrations of up to but not exceeding 0.2 ppm of aluminum, 0.15 ppm of iron, 0.02 ppm of titanium, 1.5 ppm of boron, 0.15 ppm of phosphorus, 0.01 ppm of chromium, 0.7 ppm of calcium and 0.17 ppm of magnesium. It should be noted that, although the crystal pulling step is a further refinement of the RMS and DS/RMS materials, the resistivity levels obtained are not significantly different and may appear to represent a more impure product despite the reduction in impurity concentrations achieved by said Czochralski-pulling technique. As indicated above, this circumstance results from the fact that the resistivity is a manifestation only of umcompensated charge carriers, with a decrease in the impurity levels of the various impurities actually resulting, in some instances, in an increase in the number of such uncompensated charge carriers.

The invention is further illustrated, but not limited, by the following specific examples:

Example 1

Four hundred grams of silicon metal containing 1.25% Fe and 0.48% aluminum were dissolved in 865 grams of molten aluminum alloy solvent, said aluminum containing 0.2% Cr. 0.05% Mn and 0.1% Zn, at 1050°C under a protective nitrogen atmosphere in a graphite crucible. The homogeneous Al/Si solution was cooled from 1050°C to 690°C at the rate of 60°C/hr., thereby precipitating partially purified silicon platelets. The platelets were separated from the molten aluminum by filtration through a quartz wool filter medium. The recovered platelets were washed in an aqueous HCl solution to remove adherent Al/Si eutectic material and crushed through a 6 mesh screen. The 6—20 mesh fraction was boiled with concentrated HCl and washed with boiling water. Emission spectrographic analysis showed an aluminum content of 1,000—1500 ppm and an iron content of 20—50 ppm in the recovered platelets. One thousand grams of silicon platelets from several such preparations were combined and melted in a graphite crucible at 1500°C. An acid silica slag having 25% CaO, 10% MgO and 65% $SiO_2$ in an amount of about 20% by weight was added to the silicon melt, and the mixture was periodically hand stirred using a graphite rod over a total contact time of 40 minutes. The purified silicon melt was chill cast in a graphite crucible in air, yielding 850 grams of multigrained refined metallurgical silicon (RMS). Elemental analysis showed that said RMS contained about 9 ppm of aluminum, about 13 ppm of iron, about 2 ppm of titanium, about 3 ppm of chromium, about 100 ppm of calcium and about 63 ppm of magnesium. Boron and phosphorus values were not obtaiend. The resistivity of the RMS was from about 0.1 to about 0.2 ohm-cm.

The RMS was employed as a useful, low-cost intermediate from a melt of which boules of further refined material were pulled on a rotating silicon seed rod utilizing the well-known Czochralski pulling technique. According to this known technique, the seed rod was slowly moved while maintaining an interface between the rod with said boule being grown thereon and the molten silicon from which the boules were pulled. Movements of the seed rod was at about 8.9 cm (3.5 inches) per hour, with the diameter of the boules being about 5 cm. (2 inches). The resulting Czochralski-pulled materials, i.e. Cz-RMS, was a multigrained silicon having a resistivity of from about 0.1 to about 0.2 ohm-cm, having impurity contents of about 1 ppm of aluminum, about 1.1 ppm of iron, less than about 0.5 ppm of titanium, about 0.5 ppm of chromium, less than 0.5 ppm of calcium and less than about 0.5 ppm of magnesium.

The Cz-RMS materials thus produced was used as active and passive solar cell substrate material in the production of planar diodes and related solar cell structures. Thus, multigrained p-and n-type epitaxial layers were grown on wafers of said Cz-RMS as a passive silicon substrate in the formation of n-on-p on p substrate planar diodes and related solar cells by conventional techniques known in the art. Similarly, the Cz-RMS material was employed, in the production of planar diodes and solar cells, as a p-type multigrained silicon substrate into one side of which pentavalent n-type impurities, e.g. phosphene, was diffused to form a p-n junction by known techniques.

Solar cell efficiencies were measured under Air Mass One Conditions, i.e. at 97 milliwatts/cm². "Air Mass One" refers to the intensity of light reaching a solar cell on the earth's surface with the sun at a zenith angle of 0° i.e. straight up—see "Handbook of Optics" by Driscoll and Vaughan, pub. McGraw-Hill 1978, pages 3—66. For the passive substrate cell having said epitaxial layers grown thereon, efficiencies of over 9% were obtained, e.g. 9.2% and 9.4%. Efficiencies of greater than 8% were likewise obtained with solar cells in which said Cz-RMS serves as an active substrate having a p-n junction diffused therein.

Example 2
1000 gms of metallurgical grade silicon containing 0.32% Fe and 0.21% aluminum was dissolved in 3,000 gms of the molten aluminum solvent used in Example 1 at 950°C. in a graphite crucible having a protective nitrogen atmosphere. The resulting melt was cooled at 60°C/hour to 710°C, thereby precipitating relatively pure silicon platelets. The partially purified product was scooped from the melt surface using a perforated graphite bucket and filtered through a quartz wool filter medium. Following washing in aqueous HCl to remove adhering eutectic material as in Example 1, the resulting 6—20 mesh platelet fraction was shown, by emission spectrographic analysis, to contain more than 2,000 ppm of aluminum and less than 30 ppm of iron. A melt of said platelets was contected, at 1500°C, with an acid silica slag, containing 45% BaO and 55% $SiO_2$, amounting to 20% by weight of the silicon melt. Contact time was about 30 minutes in a quartz container. The resulting multigrained RMS was found, upon elemental analysis, to contain about 15 ppm of aluminum, about 46 ppm of iron, about 14 ppm of titanium, about 1.6 ppm of chromium, about 15 ppm of calcium and about 1.8 ppm of magnesium. Boron and phosphorous were not measured. The resistivity of the material was about 0.1 to about 0.2 ohm-cm. The RMS can be effectively employed as a low-cost intermediate in the production of Cz-RMS as indicated above, with said Cz-RMS being useful as a substrate for the production of epitaxial and/or diffusion type planar diodes and corresponding solar cells having adequate solar cell efficiencies to merit consideration for practical commercial solar cell applications.

Example 3
By means of processing similar to that described in the examples above, RMS has been made from acid silica slag containing 25% $Na_2O$ and 75% $SiO_2$. The resultant RMS product is a low-cost, multigrained silicon having a resistivity of from 0.1 to 0.2 ohm-cm, with impurity concentrations of about 5.4 ppm of aluminum, about 80 ppm of iron, about 7 ppm of titanium, about 8.8 ppm of chromium, about 1.3 ppm of calcium and about 3.8 ppm of magnesium. Boron and phosphorus contents were not measured. The product RMS can likewise be used in the production of Cz-RMS suitable for use as low-cost substrate material in epitaxial and diffusion type solar cell structures capable of achieving acceptable solar cell efficiencies.

Example 4
Metallurgical grade silicon containing 1.25% iron and 0.48% aluminum is dissolved in aluminum alloy solvent containing 0.2% Cr, 0.05% Mn and 0.1% Zn at 1050°C. The solution, containing 35% Si and 63% Al, is cooled to 710°C at the rate of 60°C/hour, precipitating partially purified silicon platelets. Following washing with an aqueous HCl solution, said platelets are crushed to a 6—20 mesh size and melted in contact with a 45% BaO/55% $SiO_2$ slag employed in an amount of about 10% by weight of silicon. Upon contact in the melting zone for about 45 minutes at 1450°C, the melt is slowly removed from the melting zone in a unidrectional manner at a rate of about 15 cm. (6 inches) in a six hour time period, causing the directional solidification of the refined silicon material and with a separate region of solidified melt having a high concentration of impurities rejected by the refined metallurgical silicon as it solidified. After cropping the top containing said region of solidified melt, the resulting product is a low-cost, multi-grained directionally solidified refined metallurgical silicon (DS/RMS) having suitable properties for solar cell applications. Such DS/RMS has a resistivity level of from 0.04 to 0.2, typically 0.1 to 0.2, ohm-cm and impurity concentrations less than 1 ppm aluminum and iron, less than 2 ppm of titanium, less than 5, typically about 3, ppm of phosphorus, less than 1 ppm of chromium, less than 1 ppm of calcium and less than 1 ppm of magnesium. The boron content was not measured.

In the practice of the invention, metallurgical grade silicon containing 1.25% iron and 0.48% aluminum is dissolved in aluminum alloy solvent containing 0.2% Cr, 0.05% Mn and 0.1% Zn at 1050°C. The solution, containing 35% Si and 65% Al, is cooled to 710°C at the rate of 60°C/hour, precipitating partially purified silicon platelets. Following washing with an aqueous HCl solution, said platelets are crushed to a 6—20 mesh size and melted in a melting zinc. The melt is slowly removed from the melting zone in a unidirectional manner by lowering the melting crucible at a rate of about 15 cm. (6 inches) in a six hour time period, causing the directional solidification of the refined silicon material and the forming of a separate region of solidified melt having a high concentration of impurities rejected by the refined metallurgical silicon as it solidified. After cropping the top containing said region of solidified melt, the product obtained is a low-cost, multigrained directionally solidified refined metallurgical silicon (DS/RMS) having suitable properties for solar cell applications. Such DS/RMS has a resistivity level of about 0.05 ohm-cm and impurity concentrations of about 12.1 ppm of aluminum, about 34 ppm of iron, less than 1 ppm of titanium, less than about 2 ppm of phosphorus, less than 0.5 ppm of chromium, less than 0.5 ppm of calcium and less than 0.3 ppm of magnesium. The boron content of this sample was not measured.

The DS/RMS product can be employed as a solar cell substrate material directly, or can be further refined as by the above-indicated Czochralski-type crystal growth to produce both multigrained and single crystal Cz-DS/RMS material. All such materials can be employed as passive substrate wafers upon which epitaxial p-and n-type layers can be grown to form n-on-p-on-p substrate planar diodes and solar cells by conventional techniques. Said material can also be employed as active p-type substrates upon one side of which pentavalent n-type impurities, such as phosphene can be diffused to form a p-n junction therein by conventional means known in the art. The single crystal Cz-DS/RMS material can readily be formed by re-melting and re-directionally solidifying said DS/RMS before the pulling of boules therefrom or, less desirably, by re-melting and re-pulling boules from a melt of the boules of multigrained DS/RMS.

DS/RMS materials prepared as indicated above were melted and boules of further refined material were pulled from the melt by the Czochralski technique, using a seed pull rate of about 8.9 cm. (3.5 inches)/hour. A multigrained, CDS/RMS prepared in this manner had a resistivity of on the order of 0.05 ohm-cm, with impurity concentrations of ahout 0.19 ppm of aluminum, about 0.11 ppm of iron, about 0.03 ppm of titanium, about 1.1 ppm of boron, about 0.16 ppm of phosphorus, about 0.02 ppm of chromium, about 0.64 ppm of calcium and about 0.05 ppm of magnesium. Multigrained DS/RMS was remelted for a second generation Cz-pull, with boules being pulled from the remelt under the same conditions as in the first boule pulling step. A single crystal, Cz-DS/RMS was obtained in this manner, said material having a resisitivity of about 0.05 ohm-cm, with impurity concentrations of about 0.19 ppm of aluminum, about 0.11 ppm of iron, about 0.02 ppm of titanium, about 1.1 ppm of boron, about 0.12 ppm of phosphorus, about 0.01 ppm of chromium, about 0.64 ppm of calcium and about 0.16 ppm of magnesium. Similar impurity levels are obtainable by the more commercially preferred technique in which the RMS is directionally solidified a second time prior to the pulling of single crystal boules from a melt of said twice directionally solidified RMS.

Solar cell efficiencies of about 8.9% have been obtained using the directionally solidified refined, metallurgical silicon (DS/RMS) of the present invention as a passive substrate having epitaxial p- and n-type layers grown thereon by conventional means. Efficiencies of 10.6% for a passive substrate and 9.6% for an active substrate have been obtained utilizing a single crystal, pulled DS/RMS material. Using a multigrained, pulled DS/RMS as a passive substrate, solar cell efficiencies of up to 9.6% have been obtained.

It will be understood that all solar efficiencies are on said Air Mass One basis. It will also be appreciated that the claimed melting of partially purified platelets in contact with said silica slag includes also the contacting of a melt of said platelets with the slag to effect the desired removal of aluminum and other impurities as indicated in the examples. It is also pointed out that the silicon products will likely include impurities other than those specifically recited, the latter group being selected on the basis of their general significance to the functioning of the materials for solar cell applications and as distinguishing the products of the invention from those of the prior art. While boron and, in some specific examples, phosphorus were not measured, these impurities were included as being impurity components having some measure of effect on the performance of the products of the invention. The boron and phosphorus levels recited for said impurities have been determined on the basis of the analysis of certain specific samples of the silicon products of the invention and related general information concerning the concentration of such silicons on silicon materials.

In a further embodiment of the invention, it has been found that the refined metallurgical silicon of the invention can be employed to produce a low-cost, multigrained ribbon having suitable properties for desirable solar cell and other silicon ribbon applications. Such ribbon is advantageously pulled from the directionally solidified, multigrained refined metallurgical silicon, i.e. DS/RMS, produced as indicated above. Such ribbon, when employed as a passive solar cell substrate, with p-and n-type epitaxial layers grown thereon by known techniques to form an n-on-p-on-p substrate structure has provided solar cell efficiencies on the order of 8%. By contrast, ribbons pulled from high cost, high purity semiconductor material have achieved about 10% efficiency, while ribbons pulled from metallurgical silicon have not achieved more than about 5% efficiency. The ribbon formed from DS/RMS produced by the novel process of the invention thus offers an attractive, alternative form of solar cell substrate material, further enhancing the feasibility of low-cost, practical solar cell applications established hereinabove with respect to the indicated RMS and DS/RMS products of the invention.

The multigrained silicon ribbon of the invention is pulled from a melt of DS/RMS which is prepared by the novel process of the invention in which iron is first removed from metallurgical grade silicon by a solvent refining technique, aluminum and other impurities are removed from the essentially iron-free intermediate product by a slag oxidation method, and the silicon is slowly solidified in a unidirectional manner to form said DS/RMS and a region of solidified melt having a high concentration of the impurities rejected by the refined silicon as it solidifies in a unidirectional manner.

The ribbon can be pulled from the melt of DS/RMS by any known, commercially available ribbon pulling technique. The Edge-Defined, Film-Fed Growth (EFG) process is a convenient, commercially established technique suitable for the ribbon pulling step of the present invention. The process consists of growing crystals of predetermined shape and dimensions from a film of the melt whose shape is determined by a "die" through the apertures of which the melt is fed by capillary from a reservoir surrounding the lower part of the die. Details of this well-known ribbon pulling technique are outside the scope of the present invention which is related to the unique properties of the ribbon as derived from the novel DS/RMS starting material employed in the production of said ribbon. The EFG process is further described in a paper entitled "The Silicon Ribbon Solar Cell—A Way to Harness Solar Energy"—K. V. Ravi and A. I. Mlavsky, of Mobil Tyco Solar Energy Corporation, presented in November, 1975 at the COMPLES International Meeting in Dhahran, Saudi Arabia. Other ribbon-forming techniques are also known and available in the art.

The multigrained ribbon of the invention was prepared by the EFG process from multigrained DS/RMS having a resistivity of 0.04—0.05, and having an impurity content of about 0.19 ppm of aluminum, about 0.11 ppm of iron, about 0.03 ppm of titanium, about 1.1 ppm of boron, about 0.16 ppm of phosphorus, about 0.02 ppm of chromium, about 0.64 ppm of calcium and about 0.05 ppm of magnesium. By known techniques, epitaxial p-and n-type layers were grown on said ribbon having a thickness of on the order of 0.01 cm (0.004") to form a n-on-p-on-p substrate structure. The p-layer was about 25 microns thick and had a resistivity of about 0.2 ohm-cm. The n-layer had a thickness of about 0.5 microns and had a resistivity of about 0.015 ohm-cm. An AM1 efficiency of about 7.9% was obtained, said ribbon having an area of about 0.6 cm$^2$. It will be understood that said ribbon can be made from any such DS/RMS material produced as disclosed above, with said ribbon being pulled by the EFG process or any other known, commercially available ribbon pulling process suitable for the preparation of silicon ribbon.

It will be appreciated also that the concentrations of impurities in the DS/RMS are subject to wide fluctuation depending upon the precise materials and conditions employed in the processing steps by which the DS/RMS is prepared. The DS/RMS material and the resultant ribbon will be understood to include such material having a resistivity of from 0.04 to 0.2 ohm-cm, and having impurity concentrations of up to, but not generally exceeding, about 1 ppm of aluminum, about 1 ppm of iron, about 2 ppm of titanium, about 2 ppm of boron, about 2 ppm of phosphorus, about 1 ppm of chromium, about 1 ppm of calcium and about 1 ppm of magnesium. It will also be appreciated that specific ribbon compositions may have individual impurity component levels somewhat above the general limits set forth without departing from the scope of the novel ribbon materials disclosed and claimed herein.

The present invention provides a novel process for the production of refined metallurgical silicons having a desirable combination of low-cost and a purity level such that adequate solar efficiencies can be obtained thereby. While the products of the invention are relatively impure as compared to semiconductor grade material, they provide an attractive economic-technical alternative to the use of such high cost, high purity material. Thus, single crystal Cz-DS/RMS material was shown to achieve 10/6% efficiency as a passive substrate. Significantly, multigrained Cz-DS/RMS achieved over 9.0% efficiency, e.g. 9.2 and 9.4%, and a DS/RMS, without crystal pulling achieved an efficiency of 8.9%. Adequate solar cell efficiencies can also be achieved with low-cost active substrates made from the DS/RMS product of the present invention and from Cz-modifications of said DS/RMS and the RMS of the present invention.

The present invention thus constitutes a significant advance in the field of solar energy technology. It represents, therefore, a major step in the urgently needed development of solar energy as a commercially feasible, non-polluting energy source for satisfying significant portions of the energy needs of industrial societies throughout the world.

## Claims

1. A process for the production of refined metallurgical silicon from metallurgical grade silicon comprising:

removing silicon platelets from a solution of said metallurgical grade silicon in a liquid metal solvent thereby recovering partially purified, essentially iron-free silicon platelets with adherent impurities derived from said metal solvent;

melting said partially purified silicon platelets in contact with acid silica slag in a melting zone, the resulting slag oxidation removing residual and adherent impurities from the silicon platelets; and

cooling the thus-slagged silicon to obtain a multigrained refined metallurgical silicon having a higher impurity content level than semiconductor grade silicon but suitable for use in solar cell applications.

2. A process according to Claim 1 further comprising removing the silicon-slag melt from said melting zone in a unidirectional manner so as to directionally solidify said silicon, said directional solidification resulting in the obtaining of solidified refined metallurgical silicon and a region of solidified melt having a high concentration of impurities rejected by the refined metallurgical silicon as it solidifies.

3. A process according to Claim 1 or 2 further comprising pulling refined metallurgical silicon boules from a melt of the refined or directionally solidified silicon on a rotating silicon seed rod.

4. A process according to Claim 3 in which said seed rod is slowly moved while maintaining an interface between the rod with said boule being grown thereon and the molten silicon from which said boules are pulled.

5. A process according to Claim 2 further comprising re-melting said directionally solidified refined metallurgical silicon after the separation thereof from said region of solidified melt, and removing the resulting silicon melt from said melting zone so as to directionally solidify said silicon a second time, said directional solidification resulting in the obtainment of a solidified refined metallurgical silicon of enhanced purity and a region of solidified melt having a high concentration of the remaining impurities;

melting said directionally solidified refined metallurgical silicon of enhanced purity; and

pulling silicon boules from said melt on a rotating seed rod to obtain single grain silicon.

6. A process according to Claim 5 wherein said melting of the directionally solidified silicon and said pulling of a silicon boule from the silicon melt is repeated, and the second pulled boule constitutes said single grain silicon.

7. A process according to any one of Claims 1 to 6 in which said liquid metal solvent is aluminum or an aluminum alloy.

8. A process according to any one of Claims 1 to 7 in which said removing of silicon platelets from solution comprises cooling a liquid solution of silicon in molten aluminum to a temperature not below the eutectic temperature of about 577°C, thus forming a supersaturated hypereutectic aluminum-silicon solution and causing silicon to precipitate therefrom.

9. A process according to Claim 8 comprising melting said partially purified silicon platelets in contact with acid silica slag in a melting zone at a temperature of from 1410°C to 2000°C to remove by oxidation, aluminum from silicon, whereby the resulting $Al_2O_3$ passes into said slag.

10. A process according to Claim 9 in which said partially purified silicon platelets are contacted with said silica slag at a temperature of from 1410°C to 1600°C.

11. A process according to any one of Claims 1 to 10 in which said acid silica slag has a Si:O ratio of between 1:4 and 1:2.

12. A process according to any one of Claims 1 to 11 in which said silica slag is of high purity, the concentration of each impurity in the slag reducible by molten silicon at the silicon platelet-silica slag contacting temperature being less than 10 ppm. (where ppm. signifies parts per million).

13. A process according to any one of Claims 1 to 12, said slag being employed in an amount within the range of from 8% to 12% based on the weight of the silicon platelets melted in contact therewith.

14. A process according to any one of Claims 1 to 12, comprising filtering said partially purified platelets from said solution and smelting said as-filtered platelets having adherent eutectic thereon, in contact with said acid slag.

15. Refined metallurgical silicon obtained by a process according to Claim 1, comprising a multigrained silicon having a resistivity of from 0.04 to 0.2 ohm-cm, said silicon having impurity concentrations of up to, but not exceeding, 15 ppm of aluminum; 80 ppm of iron, 15 ppm of titanium, 2 ppm of boron, 2 ppm of phosphorus, 10 ppm of chromium, 100 ppm of calcium, and 65 ppm of magnesium (where ppm signifies parts per million).

16. Refined metallurgical silicon obtained by a process according to Claim 2, comprising a multigrained silicon having a resistivity of from 0.04 to 0.2 ohm-cm, said silicon having impurity concentrations of up to, but not exceeding 1 ppm of aluminum, 1 ppm of iron, 2 ppm of titanium, 2 ppm of boron and 2 ppm of phosphorous, 1 ppm chromium, 1 ppm calcium, and 1 ppm magnesium (where ppm signifies parts per million).

17. A refined metallurgical silicon obtained by a process according to Claim 3 when appendant to Claim 1, comprising a multi-grained silicon having a resistivity of from 0.1 to 0.2 ohm-cm, said silicon having impurity concentrations of up to, but not exceeding, 1 ppm of aluminum, 1 ppm of iron, 0.5 ppm of titanium, 2 ppm of boron, 2 ppm of phosphorous, 0.5 ppm of chromium, 0.5 ppm of calcium, and 0.5 ppm of magnesium (where ppm signifies parts per million).

18. Refined metallurgical silicon obtained by a process according to Claim 3 when appendant to Claim 2, comprising a multigrained silicon having a resistivity of from 0.04 to 0.2 ohm-cm, said silicon having impurity concentrations of up to, but not exceeding, 0.03 ppm of titanium, 1.5 ppm of boron, 0.2 ppm of phosphorous, 0.02 ppm of chromium, 0.7 ppm of calcium, and 0.05 ppm of magnesium (where ppm signifies parts per million).

19. Refined metallurgical silicon obtained by a process according to Claim 5, comprising a single grain silicon having a resistivity of from 0.04 to 0.2 ohm-cm, said silicon having a impurity concentrations of up to, but not exceeding, 0.2 ppm of aluminum, 0.15 ppm of phosphorous, 0.01 ppm of chromium, 0.7 ppm of calcium, and 0.17 ppm of magnesium (where ppm signifies parts per million).

**Revendications**

1. Un procédé pour la production de silicium métallurgique raffiné à partir de silicium de qualité métallurgique, dans lequel:

on extrait des plaquettes de silicium à partir d'une solution de ce silicium de qualité métallurgique dans un solvant consistant en un métal liquide, grâce à quoi on récupère des plaquettes de silicium partiellement purifiées et pratiquement exemptes de fer, avec des impuretés adhérentes provenant du solvant consistant en un métal;

on fait fondre plaquettes de silicium partiellement purifiées, en contact avec une scorie de silice acide dans une zone de fusion, l'oxydation par scorie qui en résulte éliminant les impuretés résiduelles et adhérentes présentes sur les plaquettes de silicium; et

on refroidit le silicium ainsi traité par scorie, pour obtenir un silicium métallurgique raffiné multigrain ayant une teneur en impuretés plus élevée que du silicium de qualité semiconducteur, mais convenant à l'utilisation dans des applications concernant les cellules solaires.

2. Un procédé selon la revendication 1, dans lequel, en outre, on extrait le bain en fusion silicium-scorie à partir de la zone en fusion d'une manière unidirectionnelle, afin de solidifier le silicium de façon directionnelle, cette solidification directionnelle conduisant à l'obtention de silicium métallurgique reaffiné et solidifié et d'une région de masse solidifiée ayant une concentration élevée en impuretés rejectées par le silicium métallurgique raffiné au fur et à mesure qu'il se solidifie.

3. Un procédé selon la revendication 1 ou 2, dans lequel on tire en outre des barreaux de silicium métallurgique raffiné à partir d'un bain en fusion du silicium raffiné ou solidifié de façon directionnelle, sur une tige germe de silicium en rotation.

4. Un procédé selon la revendication 3, dans lequel on déplace lentement la tige germe tout en maintenant une jonction entre la tige sur laquelle on fait croître le barreau et le silicium en fusion à partir duquel on tire les barreaux.

5. Un procédé selon la revendication 2, dans lequel on fait en outre refondre le silicium métallurgique raffiné et solidifié de façon directionnelle, après l'avoir séparé de la région de masse solidifiée, et on extrait de la zone de fusion le bain en fusion de silicium résultant, afin de solidifier le silicium de façon directionnelle une seconde fois, cette solidification directionnelle conduisant à l'obtention d'un silicium métallurgique raffiné et solidifié ayant une pureté accrue et d'une région de masse solidifiée ayant une concentration élevée des impuretés restantes;

on fait fondre ce silicium métallurgique raffiné et solidifié de façon directionnelle, de pureté accrue; et

on tire des barreaux de silicium à partir du bain en fusion, sur une tige germe en rotation, pour obtenir du silicium monocristallin.

6. Un procédé selon la revendication 5, dans lequel on répète la fusion du silicium solidifié de façon directionnelle et le tirage d'un barreau de silicium à partir du bain en fusion de silicium, et le second barreau tiré constitue ledit silicium monocristallin.

7. Un procédé selon l'une quelconque des revendications 1 à 6, dans lequel le solvant consistant en un métal liquide est de l'aluminium ou un alliage d'aluminium.

8. Un procédé selon l'une quelconque des revendications 1 à 7, dans lequel l'extraction de plaquettes de silicium à partir d'une solution comprend le refroidissement d'une solution liquide de silicium dans de l'aluminium en fusion, jusqu'à une température qui n'est pas inférieure à la température eutectique d'environ 577°C, ce qui forme une solution aluminium-silicium hyper-eutectique sursaturée, et provoque la précipitation du silicium à partir de la solution.

9. Un procédé selon la revendication 8, dans lequel on fait fondre les plaquettes de silicium partiellement purifiées, en contact avec une scorie de silice acide, dans une zone de fusion, à une température de 1410°C à 2000°C, afin d'éliminer par oxydation l'aluminium contenu dans le silicium, le Al$_2$O$_3$ résultant passant dans la scorie.

10. Un procédé selon la revendication 9, dans lequel les plaquettes de silicium partiellement purifiées sont mises en contact avec la scorie de silice à une température de 1410°C à 1600°C.

11. Un procédé selon l'une quelconque des revendications 1 à 10, dans lequel la scorie de silice acide a un rapport Si:O compris entre 1/4 et 1/2.

12. Un procédé selon l'une quelconque des revendications 1 à 11, dans lequel la scorie de silice a une pureté élevée, la concentration dans la silice de chaque impureté réductible par le silicium en fusion à la température de contact entre les plaquettes de silicium et la scorie de silice étant inférieure à 10 ppm (ppm signifiant parties par million).

13. Un procédé selon l'une quelconque des revendications 1 à 12, dans lequel la scorie est employée en une quantité comprise dans la plage de 8% à 12%, sur la base du poids des plaquettes de silicium qui sont fondues en contact avec la scorie.

14. Un procédé selon l'une quelconque des revendications 1 à 12, dans lequel on filtre les plaquettes partiellement purifiées, à partir de la solution, et on fait fondre en contact avec la scorie acide ces plaquettes résultant du filtrage, qui portent un eutectique adhérent.

15. Silicium métallurgique raffiné obtenu par un procédé conforme à la revendication 1, consistant en un silicium multigrain ayant une résistivité de 0,04 à 0,2 ohm-cm, ce silicium ayant des concentrations en impuretés atteignant, mais ne dépassant pas, 15 ppm d'aluminium, 80 ppm de fer, 15 ppm de titane, 2 ppm de bore, 2 ppm de phosphore, 10 ppm de chrome, 100 ppm de calcium et 65 ppm de magnésium (ppm signifiant parties par million).

16. Silicium métallurgique raffiné obtenu par un procédé conforme à la revendication 2, consistant en un silicium multigrain ayant une résistivité de 0,04 à 0,2 ohm-cm, ce silicium ayant des concentrations en impuretés atteignant, mais ne dépassant pas, 1 ppm d'aluminium, 1 ppm de fer, 2 ppm de titane, 2 ppm de bore et 2 ppm de phosphore, 1 ppm de chrome, 1 ppm de calcium, et 1 ppm de magnésium (ppm signifiant parties par million).

17. Un silicium métallurgique raffiné obtenu par un procédé conforme à la revendication 3, considérée comme dépendante de la revendication 1, consistant en un silicium multigrain ayant une résistivité de 0,1 à 0,2 ohm-cm, ce silicium ayant des concentrations en impuretés atteignant, mais ne dépassant pas, 1 ppm d'aluminium, 1 ppm de fer, 0,5 ppm de titane, 2 ppm de bore, 2 ppm de phosphore, 0,5 ppm de chrome, 0,5 ppm de calcium et 0,5 ppm de magnésium (ppm signifiant parties par million).

18. Silicium métallurgique raffiné obtenu par un procédé conforme à la revendication 3, considérée comme dépendante de la revendication 2, consistant en un silicium multigrain ayant une résistivité de 0,04 à 0,2 ohm-cm, ce silicium ayant des concentrations en impuretés atteignant, mais ne dépassant pas, 0,03 ppm de titane, 1,5 ppm de bore, 0,2 ppm de phosphore, 0,02 ppm de chrome, 0,7 ppm de calcium et 0,05 ppm de magnésium (ppm signifiant parties par million).

19. Silicium métallurgique raffiné obtenu par un procédé conforme à la revendication 5, consistant en un silicium monograin ayant une résistivité de 0,04 à 0,2 ohm-cm, ce silicium ayant des concentrations en impuretés atteignant, mais ne dépassant pas, 0,2 ppm d'aluminium, 0,15 ppm de phosphore, 0,01 ppm de chrome, 0,7 ppm de calcium et 0,17 ppm de magnésium (ppm signifiant parties par million).

**Patentansprüche**

1. Verfahren zum Herstellen von gereinigtem metallurgischem Silizium aus metallurgischem Silizium, dadurch gekennzeichnet, daß

Siliziumplättchen aus einer Lösung des metallurgischen Siliziums in einem flüssigen metallischen Lösungsmittel unter Gewinnung von teilgereinigten, im wesentlichen eisenfreien Siliziumplättchen mit von dem metalli-schen Lösungsmittel stammenden anhaften-den Verunreinigungen abgezogen werden;

die teilgereinigten Siliziumplättchen in Kontakt mit saurer Siliziumdioxidschlacke in einer Schemlzzone geschmolzen werden und durch die dabei eintretende Schlackeoxidation restliche und anhaftende Verunreinigungen von den Siliziumplättchen entfernt werden; und

das derart abgeschlackte Silizium unter Gewinnung eines mehrkristallinen gereinigten metallurgischen Siliziums abgeschlackt wird, das einen Gehalt an Verunreinigungen hat, der höher als der von Halbleitersilizium, aber für eine Verwendung bei Solarzellenanwendungen geeignet ist.

2. Verfahren nach Anspruch 1, dadurch gekennzeichnet, daß die Silizium-Schlacke-Schmelze aus der Schmelzzone einseitig gerichtet abgezogen wird, um das Silizium gerichtet ers-

14

tarren zu lassen, wobei die gerichtete Erstarrung zu der Bildung von erstarrtem gereinigtem metallurgischem Silizium und eines Bereichs an erstarrter Schmelze führt, der eine hohe Konzentration an Verunreinigungen hat, die von dem gereinigten metallurgischen Silizium abgestoßen werden, während es erstarrt.

3. Verfahren nach Anspruch 1 oder 2, dadurch gekennzeichnet, daß Körper aus gereinigtem metallurgischem Silizium aus einer Schmelze des gereinigten oder gerichtet erstarrten Siliziums auf einem rotierenden Siliziumkeimstab gezogen werden.

4. Verfahren nach Anspruch 3, dadurch gekennzeichnet, daß der Keimstab langsam bewegt wird, während zwischen dem Stab mit dem darauf wachsenden Körper und dem schmelzflüssigen Silizium, aus dem die Körper gezogen werden, eine Grenzfläche aufrechterhalten wird.

5. Verfahren nach Anspruch 2, dadurch gekennzeichnet, daß das gerichtet erstarrte gereinigte metallurgische Silizium nach seinem Abtrennen von dem Bereich der erstarrten Schmelze umgeschmolzen wird und die erhaltene Siliziumschmelze aus der Schmelzzone derart entnommen wird, daß das Silizium ein zweites Mal gerichtet erstarrt, wobei die gerichtete Erstarrung zur Ausbildung eines erstarrten gereinigten metallurgigischen Siliziums von verbesserter Reinheit und eines Bereichs aus erstarrter Schmelze führt, der eine hohe Konzentration an Verunreinigungen hat, die von führt;

das gerichtet erstarrte gereinigte metallurgische Silizium von verbesserter Reinheit geschmolzen wird; und

auf einem rotierendem Keimstab Siliziumkörper aus dieser Schmelze unter Bildung von einkristallinem Silizium gezogen werden.

6. Verfahren nach Anspruch 5, dadurch gekennzeichnet, daß das Schmelzen des gerichtet erstarrten Siliziums und das Ziehen eines Siliziumkörpers aus der Siliziumschmelze wiederholt werden und der zweite gezogene Körper das einkristalline Silizium bildet.

7. Verfahren nach einem der Ansprüche 1 bis 6, dadurch gekennzeichnet, daß als flüssiges metallisches Lösungsmittel Aluminium oder eine Aluminiumlegierung verwendet werden.

8. Verfahren nach einem der Ansprüche 1 bis 7, dadurch gekennzeichnet, daß bei dem Abziehen der Siliziumplättchen aus der Lösung eine flüssige Lösung von Silizium in schmelzflüssigem Aluminium auf eine nicht unterhalb der eutektischen Temperatur von etwa 577°C liegende Temperatur abgekühlt wird, wodurch eine übersättigte, hypereutektische Aluminium-Silizium-Lösung gebildet und das Silizium zum Ausfällen aus dieser Lösung gebracht wird.

9. Verfahren nach Anspruch 8, dadurch gekennzeichnet, daß die teilgereinigten Siliziumplättchen in Kontakt mit saurer Siliziumdioxidschlacke in einer Schmelzzone bei einer Temperatur von 1410°C bis 2000°C zwecks Beseitigung von Aluminium von dem Silizium durch Oxidation geschmolzen werden, wodurch das erhaltene $Al_2O_3$ in die Schlacke übergeht.

10. Verfahren nach Anspruch 9, dadurch gekennzeichnet, daß die teilgereinigten Siliziumplättchen mit der Siliziumdioxidschlacke bei einer Temperatur von 1410°C bis 1600°C in Kontakt gebracht werden.

11. Verfahren nach einem der Ansprüche 1 bis 10, dadurch gekennzeichnet, daß die saure Siliziumdioxidschlacke ein Si:O-Verhältnis zwischen 1:4 und 1:2 hat.

12. Verfahren nach einem der Ansprüche 1 bis 11, dadurch gekennzeichnet, daß die Siliziumdioxidschlacke von hoher Reinheit ist und die Konzentration jeder Verunreinigung in der Schlacke, die durch schmelzflüssiges Silizium bei der Kontakttemperatur von Siliziumplättchen und Siliziumdioxidschlacke reduzierbar ist, kleiner als 10 ppm ist (wobei ppm Teile pro Million bedeutet).

13. Verfahren nach einem der Ansprüche 1 bis 12, dadurch gekennzeichnet, daß die Schlacke in einer Menge im Bereich von 8% bis 12%, bezogen auf das Gewicht der in Kontakt damit geschmolzenen Siliziumplättchen, verwendet wird.

14. Verfahren nach einem der Ansprüche 1 bis 12, dadurch gekennzeichnet, daß die teilgereinigten Plättchen aus der Lösung abgefiltert und die abgefilterten Plättchen, an denen Eutektikum anhaftet, in Kontakt mit der sauren Schlacke geschmolzen werden.

15. Gereinigtes metallurgisches Silizium das durch ein Verfahren nach Anspruch 1 gewonnen ist, gekennzeichnet durch ein mehrkristallines Silizium mit einem spezifischen elektrischen Widerstand von 0,04 bis 0,2 Ohm cm, wobei das Silizium Verunreinigungskonzentrationen aufweist, die die folgenden Werte nicht überschreiten: 15 ppm Aluminium, 80 ppm Eisen, 15 ppm Titan, 2 ppm Bar, 2 ppm Phosphor, 10 ppm Chrom, 100 ppm Calcium und 65 ppm Magnesium (wobei ppm Teile pro Million bedeutet).

16. Gereinigtes metallurgisches Silizium, das durch ein Verfahren nach Anspruch 2 gewonnen ist, gekennzeichnet durch ein mehrkristallines Silizium mit einem spezifischen elektrischen Widerstand von 0,04 bis 0,2 Ohm cm, wobei das Silizium Verunreinigungskonzentrationen aufweist, die die folgenden Werte nicht überschreiten: 1 ppm Aluminium, 1 ppm Eisen, 2 ppm Titan, 2 ppm Bor, 2 ppm Phosphor, 1 ppm Chrom, 1 ppm Calcium und 1 ppm Magnesium (wobei ppm Teile pro Million bedeutet).

17. Gereinigtes metallurgisches Silizium, das durch ein Verfahren nach Anspruch 3, abhängig von Anspruch 1, gewonnen ist, gekennzeichnet durch ein mehrkristallines Silizium mit einem spezifischen elektrischen Widerstand von 0,1 bis 0,2 Ohm cm, wobei das Silizium Verunreinigungskonzentrationen aufweist, die die folgenden Werte nicht überschreiten: 1 ppm Aluminium, 1 ppm Eisen, 0,5 ppm Titan, 2 ppm Bor, 2 ppm Phosphor, 0,5 ppm Chrom, 0,5 ppm Calcium und 0,5 ppm Magnesium (wobei ppm Teile pro Million bedeutet).

18. Gereinigtes metallurgisches Silizium, das durch ein Verfahren nach Anspruch 3, abhängig von Anspruch 2, gewonnen ist, gekennzeichnet durch ein mehrkristallines Silizium mit einem spezifischen elektrischen Widerstand von 0,04 bis 0,2 Ohm cm, wobei das Silizium Verunreinigungskonzentrationen aufweist, die die folgenden Werte nicht überschreiten: 0,03 ppm Titan, 1,5 ppm Bor, 0,2 ppm Phosphor, 0,02 ppm Chrom, 0,7 ppm Calcium und 0,05 ppm Magnesium (wobei ppm Teile pro Million bedeutet).

19. Gereinigtes metallurgisches Silizium, das durch ein Verfahren nach Anspruch 5 gewonnen ist, gekennzeichnet durch ein einkristallines Silizium mit einem spezifischen elektrischen Widerstand von 0,04 bis 0,2 Ohm cm, wobei das Silizium Verunreinigungskonzentrationen aufweist, die die folgenden Werte nicht überschreiten: 0,2 ppm Aluminium, 0,15 ppm Phosphor, 0,01 ppm Chrom, 0,7 ppm Calcium und 0,17 ppm Magnesium (wobei ppm Teile pro Million bedeutet).